Europäisches Patentamt

European Patent Office

Office européen des brevets

(19)

(11) Veröffentlichungsnummer : **0 124 019**
**B1**

(12) **EUROPÄISCHE PATENTSCHRIFT**

(45) Veröffentlichungstag der Patentschrift :
23.11.89

(21) Anmeldenummer : 84104363.1

(22) Anmeldetag : 17.04.84

(51) Int. Cl.⁴ : **H 03 H   9/64,** H 03 H   3/08,
H 03 H   9/25

(54) **Oberflächenwellen-Resonatorfilter.**

(30) Priorität : 22.04.83 DE 3314725

(43) Veröffentlichungstag der Anmeldung :
07.11.84 Patentblatt 84/45

(45) Bekanntmachung des Hinweises auf die Patenterteilung : 23.11.89 Patentblatt 89/47

(84) Benannte Vertragsstaaten :
AT BE DE FR GB IT NL SE

(56) Entgegenhaltungen :
GB—A— 2 060 305
US—A— 4 267 534
PATENTS ABSTRACTS OF JAPAN, Band 4, Nr. 56 (E-
8) [538], 25. April 1980, Seite 100 E 8; & JP - A - 55 26
723 (NIPPON DENSHIN DENWA KOSHA) 26.02.1980

(73) Patentinhaber : **Siemens Aktiengesellschaft**
**Wittelsbacherplatz 2**
**D-8000 München 2 (DE)**

(72) Erfinder : **Bulst, Wolf-Eckhart, Dipl.-Phys.**
**Arnikastrasse 2**
**D-8011 Baldham (DE)**

## Beschreibung

Die vorliegende Erfindung bezieht sich auf ein Oberflächenwellen-Resonatorfilter nach dem Oberbegriff des Patentanspruchs 1.

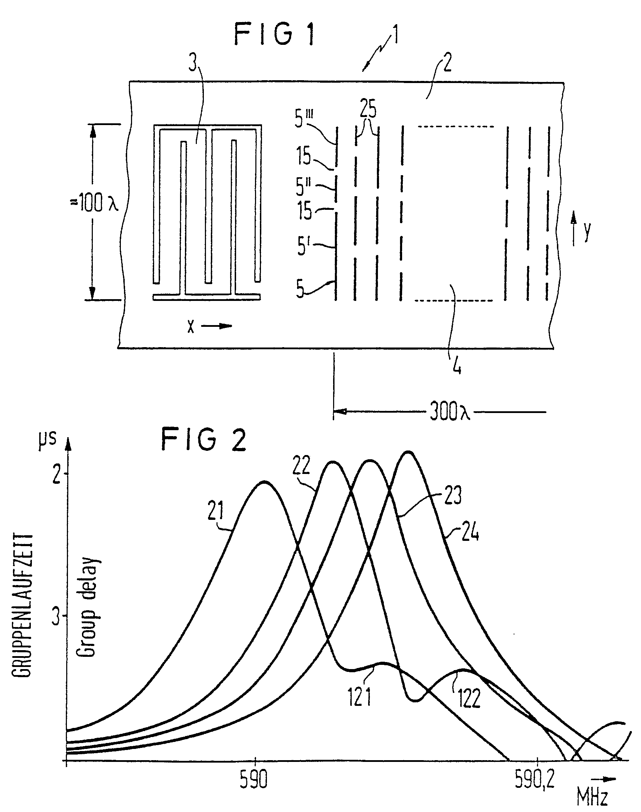

Aus « IEEE Transactions on Sonics and Ultrasonics », Bd. SU-25, No. 3 (1978), Seiten 138-146 ist ein Oberflächenwellen-Resonatorfilter bekannt, dessen Reflektorstruktur, wie die dortige Fig. 1 zeigt, anstelle von durchgehenden Metallisierungsstreifen ein Feld von Metallisierungspunkten, und zwar in regelmäßiger waffelförmiger Verteilung, hat. Die in Richtung quer zur Wellenausbreitungsrichtung aufeinanderfolgenden Metallisierungsflecken ersetzen einen jeweiligen Metallisierungsstreifen üblicher Reflektorstruktur. Die einzelnen Metallisierungsflecken haben Abmessungen in der Größenordnung der Wellenlänge oder Bruchteilen der Wellenlänge derjenigen Wellen, für die die jeweilige Reflektorstruktur bestimmt ist. Bei einer Streifenlänge von z. B. hundert Wellenlängen ergeben sich dann für einen jeden einzelnen Streifen z. B. fünfzig Unterbrechungen. Die Fig. 4 dieser Druckschrift zeigt das Ergebnis, nämlich daß Nebenmaxima der Frequenzkurve eines in der Weise ausgebildeten Filters nur noch schwach ausgeprägt sind. Es wird dies darauf zurückgeführt, daß sich in Richtung der einzelnen Metallisierungsstreifen in diesen Streifen kein elektrischer Stromfluß ausbilden kann, der zu darauf beruhenden Quermoden führt und wesentliche Veränderungen der Laufzeitgeschwindigkeit der gewolltermaßen sich ausbreitenden Längswelle zur Folge hat.

Eine gemäß der obengenannten Druckschrift geforderte außerordentlich vielfache Unterbrechung der üblicherweise verwendeten Metallisierungsstreifen bedeutet zusätzlichen hohen entwurfstechnischen (wie auch technologischen) Aufwand für die Herstellung eines solchen Filters.

Sinngemäß Gleiches zeigt die GB-A-2 060 305, nämlich wiederum in einzelne Metallisierungspunkte aufgelöste Reflektorfinger, die hier jedoch schräggerichtet angeordnet sind, und zwar entsprechend dem Winkel, in dem die Reflektorstruktur der GB-A die Welle reflektieren soll. Die Metallisierungspunkte sind auch hier ganz regelmäßig angeordnet bzw. verteilt. Die Anordnung nach Fig. 6 ist hinsichtlich bzw. in Richtung der « Reflektorfinger » ebenfalls regelmäßig. Die ebenfalls regelmäßige Abstufung von Größe und Abstand der Metallisierungspunkte aufeinanderfolgender « Reflektorfinger » entspricht der für diesen speziellen Fall vorgegebenen Dispersion.

Man hat bereits untersucht (US-A-4 340 834), wie weit das Ergebnis verschlechtert ist, wenn nur je vier Unterbrechungen bei einer Anzahl Finger der Reflektorstruktur vorgesehen sind. Dabei sind diese Unterbrechungen bei allen dafür vorgesehenen Fingern untereinander übereinstimmend lokalisiert worden, d. h. alle Unterbrechungen liegen in einer Reihe nebeneinander. Hierzu siehe Fig. 1 und 4a der US-Patentschrift. Dieses Prinzip übereinstimmender, jeweils genau nebeneinanderliegender Unterteilungen liegt auch bei allen weiteren Beispielen dieser US-Patentschrift vor.

Im Gegensatz zu Anordnungen der oben erörterten Druckschrift « IEEE Transactions... " ist bei den Anordnungen der US-Patentschrift 4 340 834 das Auftreten von Quermoden wieder bewußt in Kauf genommen worden. Durch die Unterbrechungen bilden sich dort wegen der Regelmäßigkeit ihrer Anordnung parallel gerichtet zur Wellenausbreitung der Längswelle nebeneinanderliegende Streifen mit voneinander unterschiedlichen Ausbreitungsgeschwindigkeiten aus (siehe US-PS-4 340 834, Spalte 5). Mit dem Auftreten dieser Streifen werden dort die schädlichen Wirkungen der aufgetretenen Quermoden vermindert, wobei aber zusätzliche Dämpfung für die gewünschte Welle auftritt.

Nach Fig. 4B der US-Patentschrift ist das dort erreichte Ergebnis derart, daß in der Kurve des Dämpfungsverlaufs keine Nebenmaxima der Quermoden mehr zu erkennen sind. Wegen des logarithmischen Maßstabes der Dämpfungskurve würden dort aber ohnehin auch nur sehr beträchtliche Nebenmaxima erkennbar sein. Maßgeblich ist jedoch der Verlauf der Gruppenlaufzeit, die als lineare Funktion die Relevanz noch vorhandener Nebenmaxima wesentlich deutlicher erkennen läßt und auf diese Gruppenlaufzeit kommt es für die Signalübertragung mit einem derartigen Filter letztendlich entscheidend an.

Eine für einen anderen Zweck, nämlich für Fingerwichtung, ausgestaltete Reflektorstruktur zeigt Fig. 1 in « Electronics Letters, Bd. 16 (9.10.1980), Seiten 793-794. Dem entspricht die US-A-4 267 534. Es ist dort für einen Anteil der Reflektorstruktur vorgesehen, anstelle über die ganze Breite der Struktur durchgehende Reflektorelemente vorzusehen, der für das jeweilige Reflektorelement vorgesehenen Wichtung entsprechend Längenanteile dieses Elementes wegzulassen. Diese Weglassungen sind über die ganze Länge des jeweiligen Reflektorelementes verteilt, so daß ein einzelnes gewichtetes Reflektorelement aus — in Richtung des einzelnen Reflektorelementes, d. h. quer zur Wellenausbreitung der Oberflächeenwelle gesehen — einzelnen Reflektorelement-Stücken besteht, zwischen denen (in dieser Querrichtung) erhebliche Abstände vorliegen. Die Reflektorelement-Stücke haben alle eine gleich große Länge und ihre oben angesprochenen Abstände (in Querrichtung) voneinander sind für jedes Reflektorelement der vorgegebenen Wichtung des einzelnen Reflektorelements entsprechend mehr oder weniger groß. Da bei dieser bekannten Reflektorstruktur die einzelnen streifenförmigen Reflektorelemente und auch die Reflektorelement-Stücke in die Oberfläche des Substrats hineingeätzte Gruben sind, d. h. diesbezüglich keinerlei Metallisierung der Oberfläche vorliegt, sind solche wie bei einer Anordnung nach der eingangs beschriebenen Druckschrift auftretenden elektrischen Ströme quer zur Wellenausbreitungsrichtung (d. h. solche Ströme, die zu Quermoden führen) bei dieser Ausführungsform mit Gruben ohnehin unmöglich. Die bei dieser Anordnung aus grubenförmigen Reflektorelement-Stücken bestehenden gewichteten Reflektorelemente weisen somit mehrfache Unterbrechungen, aber jeweils gleich lange Reflektorelement-Stücke auf.

Die JP-A-55-26 723 zeigt eine Oberflächenwellenstruktur, die für aus jeglicher Richtung einfallende Welle keine Reflexions- und keine Beugungswirkung für eine spezielle Richtung hat. Dies ist dort durch zweidimensionale Zufallsverteilung von Polen erreicht.

Es ist eine Aufgabe der vorliegenden Erfindung, ein Oberflächenwellen-Resonatorfilter anzugeben, das (zumindest ebenso weitgehend wie das Filter der obengenannten Druckschrift « IEEE Transactions... ») einen infolge von Unterdrückung des Entstehens von Quermoden von Nebenmaxima freien Verlauf der Gruppenlaufzeit hat, wobei dieses Filter jedoch mit kleinerem Aufwand herzustellen sein soll und/oder keinen neuen Filter-Entwurf benötigt.

Diese Aufgabe wird mit einem Oberflächenwellen-Resonatorfilter des Oberbegriffes des Patentanspruchs 1 erfindungsgemäß mit Hilfe der Lehre des Kennzeichens des Patentanspruchs 1 gelöst. Weitere Ausgestaltungen und Weiterbildungen der Erfindung gehen aus den Unteransprüchen hervor.

Von dem obengenannten Stand der Technik ausgehende Überlegungen des Erfinders haben dazu geführt, daß die dort zwingend vorgeschriebene äußerst feine Unterteilung der einzelnen Streifen der jeweiligen Reflektorstruktur, nämlich in Teillängen mit Abmessungen in der Größe der Wellenlänge, dann nicht erforderlich sind, wenn man dafür sorgt, daß bei weniger häufiger Unterbrechung oder gar bei Unterbrechungen in nur geringer Anzahl erreicht werden kann, daß störende Quermoden dennoch nicht auftreten können. Die durch praktische Versuche bestätigten Überlegungen des Erfinders resultierten in der Lehre, die erfindungsgemäß nur wenigen Unterbrechungen des jeweils einzelnen Metallisierungsstreifens, d. h. die sich ergebenden Teillängen innerhalb eines solchen Metallisierungsstreifens, von Streifen zu Streifen so zu verteilen, daß insgesamt, d. h. für die ganze Struktur, eine völlig ungeordnete Verteilung der Unterbrechungen, d. h. eine mathematische Zufallsverteilung, vorliegt. Dabei kann zwar der Zufallswahrscheinlichkeit entsprechend ein Streifen dieselbe Unterteilung wie sein Nachbarstreifen haben. Über die Gesamtheit der Metallisierungsstreifen hinweg betrachtet läßt sich aber keine Ordnung der jeweiligen Unterteilung der einzelnen Metallisierungsstreifen angeben. Aus jeweils ungeordneten Unterteilungen der einzelnen Streifen ergibt sich dann zwangsläufig, daß der jeweilige der einzelnen Streifen aus der Anzahl der jeweiligen Unterbrechungen des betreffenden Streifens entsprechend zufällig verteilt bemessenen Teillängen besteht.

Die erfindungsgemäß zu verwendende Zufallsverteilung kann z. B. entsprechend der Aussage eines Zufallsgenerators vorgegeben werden, wobei für die einzelnen Metallisierungsstreifen eine jeweils gleiche Anzahl von über dessen Länge zufällig verteilten Unterbrechungen, z. B. zwei oder fünf oder zehn Unterbrechungen für den einzelnen Metallisierungsstreifen, vorgegeben werden kann. Im Rahmen der Erfindung kann aber auch zusätzlich vorgesehen sein, auch die Anzahl der Unterbrechungen eines jeweiligen Metallisierungsstreifens dem Zufall zu überlassen, d. h. auch diesbezüglich eine Zufallsverteilung z. B. zwischen wenigstens zwei Unterbrechungen und maximal zehn Unterbrechungen vorzusehen.

Im Regelfall sind (maximal) zehn Unterbrechungen für einen jeweiligen Metallisierungsstreifen einer solchen Reflektorstruktur völlig ausreichend, um ganz wesentliche und für die Praxis im Regelfall völlig ausreichende Unterdrückung der sonst auftretenden Nebenwellen zu erreichen.

Für die zu lösende Aufgabe sind die durch diese Unterbrechungen bewirkten Spalte kurz, nämlich wie für eine aufgabengemäße elektrische Unterbrechung erforderlich ist.

Von besonderem Vorteil ist es, die Erfindung bei einem Substrat aus Quarz oder auch aus Lithiumniobat anzuwenden, das für Oberflächenwellen-Resonanzfilter wegen seiner Konstanzeigenschaft bevorzugt verwendet wird.

Mit der Erfindung wird einerseits das Herstellungsverfahren der üblichen Reflektorstrukturen zumindest nicht wesentlich erschwert. Einzelne Unterbrechungen eines Metallisierungsstreifens zu erzeugen ist für fingergewichtete Interdigitalstrukturen ständige Praxis. Bei der Erfindung kommt aber erleichternd hinzu, daß die Genauigkeit der Lage einer jeweiligen Unterbrechung innerhalb eines jeweiligen Metallisierungsstreifens und damit auch die entstandenen Teilstücke des Streifens praktisch unbedeutend ist, da deren Lage ohnehin « zufällig » ist. Ein weiterer wesentlicher Vorteil der Erfindung ist, daß bei einer wie angegeben nur noch geringen Anzahl von Unterbrechungen der einzelnen Metallisierungsstreifen für das gesamte Resonatorfilter die Wellenausbreitungsgeschwindigkeit sich nicht wesentlich ändert, und zwar gegenüber einem Filter mit Reflektorstruktur ohne jegliche Unterbrechungen. Ein erfindungsgemäßes Resonatorfilter erfordert daher kein neues Design bzw. keinen neuen Filterentwurf, weil die nur wenigen Unterbrechungen jedes derart gewichteten Streifens keinen gravierenden Einfluß auf die Ausbreitungsgeschwindigkeit der Welle haben. Für ein Filter nach der oben eingangs genannten Druckschrift ergibt sich dagegen eine wesentlich andere Frequenzlage der Resonanz vergleichsweise zum Filter ohne derartige Waffelstruktur des Reflektors. Es wird im Rahmen der Erfindung vorteilhafterweise also zunächst die betreffende Struktur mit Metallisierungsstreifen ohne Unterbrechungen hergestellt und dann erst werden die Unterbrechungen — erfindungsgemäß mathematisch zufällig verteilt — angebracht.

Weitere Erläuterungen der Erfindung gehen aus den nachfolgenden Figuren hervor.

Fig. 1 zeigt ein erfindungsgemäßes Resonatorfilter.

Fig. 2 zeigt das Ergebnis anhand gewisser Frequenzgänge von erfindungsgemäßen Resonatorfiltern.

Fig. 1 zeigt ein erfindungsgemäßes Resonatorfilter 1, das sich auf einem Substrat 2 aus Quarz befindet. Mit 3 ist eine wie übliche Interdigitalstruktur bezeichnet, die als Eingangs- und/oder Ausgangswandler verwendet wird. Von dem Resonatorfilter 1 ist — bezogen auf die Wellenausbreitungsrichtung x — nur ein Ausschnitt dargestellt, nämlich nur mit einer einzigen Reflektorstruktur 4 (zu der eine im Regelfall gleichartige Reflektorstruktur auf der in x-Richtung gegenüberliegenden Seite des Wandlers 3 gehört). Mit 5 sind die einzelnen Metallisierungsstreifen der Reflektorstruktur bezeichnet. Der Übersichtlichkeit halber ist nur eine geringe Anzahl von Streifen 5 dargestellt. Bei einer in erfindungsgemäßer Weise ausgestalteten Reflektorsturktur sind wenigstens eine Vielzahl, besser alle, Metallisierungsstreifen mit solchen zufällig verteilten Unterbrechungen versehen.

Die Reflektorstruktur 4 der Darstellung der Fig. 1 hat einen linksseitig ersten Metallisierungsstreifen 5, der zwei Unterbrechungen 15 besitzt, so daß dieser Metallisierungsstreifen 5 in drei (wie dargestellt unterschiedliche) Teillängen 5', 5'', 5''' (mit jeweils kleiner Länge der Unterbrechungen 15) zerfällt. Der rechts nächstfolgende Metallisierungsstreifen hat bei diesem Beispiel drei Unterbrechungen. Der wiederum nächstfolgende Metallisierungsstreifen hat bei diesem Beispiel dagegen vier Unterbrechungen, d. h. fünf Teillängen. Diese Darstellung soll das Prinzip erläutern, und zwar bereits mit der weiteren Ausgestaltung mit zufallsgemäß unterschiedlicher Anzahl der Unterbrechungen der einzelnen Metallisierungsstreifen 5.

Durchaus im Rahmen der zufallsgemäßen Verteilung der Unterrechungen können die beiden mit 25 gesondert bezeichneten Metallisierungsstreifen, wie dargestellt, je zwei solche Unterbrechungen haben, die sich nebeneinander an gleichem Ort befinden. Dies widerspricht nicht dem Prinzip des Zufalls, tritt aber innerhalb der gesamten Reflektorstruktur der Wahrscheinlichkeit entsprechend nur äußerst selten auf.

Fig. 2 zeigt vier Frequenzkurven für die Gruppenlaufzeit. Sie entsprechen im wesentlichen der Fig. 4 der obengenannten Druckschrift. Die mit 21 bezeichnete Frequenzkurve wurde an einem Oberflächenwellen-Resonatorfilter gemessen, das Reflektorstrukturen ohne Unterbrechungen der Metallisierungsstreifen hatte. Die Kurve 22 dagegen wurde an einem Resonatorfilter gemessen, bei dem alle Metallisierungsstreifen der Reflektorstrukturen jeweils nur eine einzige Unterbrechung, diese aber auch bereits dem Zufall entsprechend verteilt, haben. Bei beiden Kurven 21 und 22 sind deutliche Nebenmaxima 121 und 122 zu erkennen. Es sei darauf hingewiesen, daß deren Höhen wie im Betrieb notwendiger erfolgter Anpassung sehr viel höher sind und ohne weiteres auch bis zur Höhe des gewollten Maximums der Filterkurve reichen können.

Mit 23 ist die Filterkurve eines Resonatorfilters mit je zwei Unterbrechungen in jedem Metallisierungsstreifen der Reflektorstrukturen wiedergegeben. Die Kurve 24 wurde an einem Filter mit Reflektorstrukturen gemessen, deren Metallisierungsstreifen je drei Unterbrechungen haben.

Erfindungsgemäß sind diese zweimaligen bzw. dreimaligen Unterbrechungen innerhalb der einzelnen Metallisierungsstreifen mathematisch zufällig über die jeweilige ganze Reflektorstruktur verteilt, d. h. es liegt nicht nur zufällige Verteilung für die Teillängen 5', 5'', 5'''... des einzelnen Streifens 5, sondern auch zufällige Verteilung für alle Streifen 5, 25 untereinander vor.

Fig. 2 gibt das überraschende Ergebnis deutlich wieder, nämlich daß bereits zwei Unterbrechungen je Streifen 5, 25 ein praktisch vollständig zufriedenstellendes Ergebnis liefern. Daraus ist ersichtlich, daß der Herstellungsaufwand eines erfindungsgemäßen Resonatorfilters, d. h. eines Resonatorfilters, bei dem bereits völlige Beseitigung der Nebenmaxima erreicht ist, ohne wesentlichen Zusatzaufwand realisiert werden kann und insbesondere keine Feinstaufteilung der Metallisierungsstreifen erfordert, wie sie entsprechend der obengenannten Druckschrift vorgeschrieben sind.

Es kann schon ausreichend sein, von den mehreren Reflektorstrukturen, z. B. bei zwei Reflektorstrukturen 4, zwischen denen sich der (die) Eingangs- und Ausgangswandler befindet (n), nicht alle bzw. nur die eine Reflektorstruktur mit erfindungsgemäß bemessenen bzw. verteilten mehrfachen Unterbrechungen der Metallisierungsstreifen auszuführen.

## Patentansprüche

1. Oberflächenwellen-Resonatorfilter mit wenigstens zwei Reflektorstrukturen, bestehend aus Metallisierungsstreifen und mit wenigstens einem Interdigitalwandler auf einem Substrat aus piezoelektrischem Material, in dem eine Wellenausbreitung in zu den Metallisierungsstreifen senkrechter Richtung (x) vorliegt, wobei diese Metallisierungsstreifen in Querrichtung (y) zu dieser Wellenausbreitungsrichtung (x) mehrfach unterbrochen sind, gekennzeichnet dadurch, daß für wenigstens eine Reflektorstruktur für wenigstens eine Vielzahl ihrer Metallisierungsstreifen (5, 25) eine mathematisch zufällige Verteilung der Unterbrechungen vorgesehen ist, so daß die sich bei den Metallisierungsstreifen aus ihren Unterbrechungen ergebenden Teillängen (5', 5'', 5''') dieser zufälligen Verteilung entsprechend unterschiedlich sind.

2. Oberflächenwellen-Resonatorfilter nach Anspruch 1, gekennzeichnet dadurch, daß das piezoelektrische Material des Substrats Quarz ist.

3. Oberflächenwellen-Resonatorfilter nach Anspruch 1 oder 2, gekennzeichnet dadurch, daß wenigstens zwei Unterbrechungen eines jeden Metallisierungsstreifens vorliegen.

4. Oberflächenwellen-Resonatorfilter nach Anspruch 1, 2 oder 3, gekennzeichnet dadurch, daß maximal zehn Unterbrechungen eines jeden Metallisierungsstreifens vorliegen.

5. Oberflächenwellen-Resonatorfilter nach einem der Ansprüche 1 bis 4, gekennzeichnet dadurch, daß die Gesamtlänge der jeweiligen Metallisierungsstreifen 50 bis 200 Wellenlängen beträgt.

6. Oberflächenwellen-Resonatorfilter nach einem der Ansprüche 1 bis 5, gekennzeichnet dadurch, daß die Folge der Unterbrechungen innerhalb eines einzelnen Metallisierungsstreifens vergleichsweise zu der jeweiligen Folge der Unterbrechungen der übrigen Metallisierungsstreifen der Aussage eines Zufallsgenerators entspricht.

7. Oberflächenwellen-Resonatorfilter nach einem der Ansprüche 1 bis 6, gekennzeichnet dadurch, daß wenigstens die überwiegende Anzahl aller Metallisierungsstreifen einer jeweiligen Reflektorstruktur gleiche Anzahl der Unterbrechungen hat.

8. Oberflächenwellen-Resonatorfilter nach einem der Ansprüche 1 bis 6, gekennzeichnet dadurch, daß die jeweilige Anzahl der Unterbrechungen für die jeweiligen einzelnen Metallisierungsstreifen einer zufälligen Verteilung entspricht.

9. Verfahren zur Herstellung einer Reflektorstruktur für eine Vorrichtung nach einem der Ansprüche 1 bis 8, gekennzeichnet dadurch, daß zunächst eine aus solchen Metallisierungsstreifen bestehende Reflektorstruktur hergestellt wird, deren Metallisierungsstreifen noch keine Unterbrechungen aufweisen, deren Filterentwurf (Design) aber bereits der vorgegebenen Übertragungsfunktion bis auf zu beseitigende Störungen genügt, und daß erst nachfolgend diese Unterbrechungen mathematisch zufällig verteilt über wenigstens die Vielzahl der Metallisierungsstreifen (5, 25) angebracht werden, so daß dann die entsprechend zufällig bemessenen Teillängen (5', 5", 5"') vorliegen.

## Claims

1. Surface acoustic wave resonator filter having at least two reflector structures, consisting of strips of metallisation and having at least one inter-digital converter on a substrate of piezoelectric material, in which a wave propagation exists in a direction (x) which is perpendicular to the strips of metallisation, these strips of metallisation being interrupted several times in the transverse direction (y) to this direction of wave propagation (x), characterized in that for at least one reflector structure for at least a plurality of its strips of metallisation (5, 25) a mathematically random distribution of the interruptions is provided so that the part lengths (5', 5", 5"') resulting in the strips of metallisation from their interruptions are different corresponding to this random distribution.

2. Surface acoustic wave resonator filter according to Claim 1, characterized in that the piezoelectric material of the substrate is quartz.

3. Surface acoustic wave resonator filter according to Claim 1 or 2, characterized in that there are at least two interruptions in each strip of metallisation.

4. Surface acoustic wave resonator filter according to Claim 1, 2 or 3, characterized in that there are a maximum of 10 interruptions in each strip of metallisation.

5. Surface acoustic wave resonator filter according to one of Claims 1 to 4, characterized in that the total length of the respective strips of metallisation is 50 to 200 wavelengths.

6. Surface acoustic wave resonator filter according to one of Claims 1 to 5, characterized in that the sequence of interruptions within each individual strip of metallisation corresponds to the information from a random number generator in comparison with the respective sequence of interruptions of the remaining strips of metallisation.

7. Surface acoustic wave resonator filter according to one of Claims 1 to 6, characterized in that at least the predominant number of all strips of metallisation of a respective reflector structure has the same number of interruptions.

8. Surface acoustic wave resonator filter according to one of Claims 1 to 6, characterized in that the respective number of interruptions for the respective individual strips of metallisation corresponds to a random distribution.

9. Method for producing a reflector structure for a device according to one of Claims 1 to 8, characterized in that firstly a reflector structure consisting of such strips of metallisation is produced, the strips of metallisation of which do not yet exhibit any interruptions but the filter design of which already satisfies the predetermined transfer function apart from faults to be eliminated, and that these interruptions are only subsequently applied with a mathematically random distribution over at least the plurality of strips of metallisation (5, 25) so that then the correspondingly randomly dimensioned part lengths (5', 5", 5"') are present.

## Revendications

1. Filtre-résonateur à ondes de surface, comportant au moins deux structures réfléchissantes constituées par des bandes de métallisation, et au moins un transducteur interdigité sur un substrat réalisé en un matériau piézoélectrique, et dans lequel il se produit une propagation des ondes dans la direction (x) perpendiculaire aux bandes de métallisation, ces bandes de métallisation étant interrompues de façon multiple dans la direction (y) transversale par rapport à cette direction de propagation (X) des ondes, caractérisé par le fait que, pour au moins une structure réfléchissante, il est prévu, pour au moins une multiplicité des bandes de métallisation (5, 25) de cette structure, une répartition, aléatoire du point de vue mathématique, des interruptions, en sorte que les éléments de longueur (5',5",5''') ; créés par les interruptions des bandes de métallisation, ont des longueurs différentes, conformément à cette répartition aléatoire.

2. Filtre-résonateur à ondes de surface suivant la revendication 1, caractérisé par le fait que le matériau piézoélectrique du substrat est du quartz.

3. Filtre-résonateur à ondes de surface suivant la revendication 1 ou 2, caractérisé par le fait qu'il est prévu au moins deux interruptions dans chaque bande de métallisation.

4. Filtre-résonateur à ondes de surface suivant la revendication 1, 2 ou 3, caractérisé par le fait qu'il est prévu au maximum dix interruptions dans chaque bande de métallisation.

5. Filtre-résonateur à ondes de surface suivant l'une des revendications 1 à 4, caractérisé par le fait que la longueur totale des bandes de métallisation est comprise entre 50 et 200 des longueurs d'onde.

6. Filtre-résonateur à ondes de surface suivant l'une des revendications 1 à 5, caractérisé par le fait que la succession des interruptions dans chaque bande de métallisation, comparée à la suite respective des interruptions des autres bandes de métallisation, correspond à l'indication fournie par un générateur de signaux aléatoires.

7. Filtre-résonateur à ondes de surface suivant l'une des revendications 1 à 6, caractérisé par le fait qu'au moins la majeure partie de toutes les bandes de métallisation de chaque structure réfléchissante possède le même nombre d'interruptions.

8. Filtre-résonateur à ondes de surface suivant l'une des revendications 1 à 6, caractérisé par le fait que le nombre respectif des interruptions pour les différentes bandes de métallisation correspond à une répartition aléatoire.

9. Procédé pour fabriquer une structure réfléchissante pour un dispositif suivant l'une des revendications 1 à 8, caractérisé par le fait qu'on réalise tout d'abord une structure réfléchissante constituée par de telles bandes de métallisation que ne comportent encore aucune interruption et dont la conception (Design) à la manière d'un filtre est cependant déjà suffisante pour fournir la fonction de transfert prédéterminée, en dehors des parasites devant être éliminés, et qu'ensuite seulement, on crée ces interruptions d'une manière répartie de façon aléatoire, du point de vue mathématique, dans au moins la multiplicité des bandes de métallisation (5, 25) de manière à obtenir les éléments de longueur (5',5",5''') dimensionnés d'une manière aléatoire correspondante.

FIG 1

FIG 2